Europäisches Patentamt

European Patent Office

Office européen des brevets

(11) Numéro de publication: **0 042 319**

**B1**

(12) **FASCICULE DE BREVET EUROPEEN**

(45) Date de publication du fascicule du brevet: **27.12.84**

(51) Int. Cl.³: **H 01 L 25/16, H 01 L 23/54**

(21) Numéro de dépôt: **81400862.9**

(22) Date de dépôt: **27.05.81**

(54) **Amplificateur linéaire hybride ultra-rapide.**

(30) Priorité: **04.06.80 FR 8012395**

(43) Date de publication de la demande:
**23.12.81 Bulletin 81/51**

(45) Mention de la délivrance du brevet:
**27.12.84 Bulletin 84/52**

(84) Etats contractants désignés:
**BE CH DE GB IT LI NL**

(56) Documents cités:
GB-A-1 213 726

ELECTRICAL DESIGN NEWS, vol. 14, no. 17,
septembre 1969; DENVER (US) J.A. ROSE:
"Hybrids move ahead in 1969", pages 49-57
IBM TECHNICAL DISCLOSURE BULLETIN, vol.
10, no. 8, janvier 1968, NEW YORK (US) J.J.
McDOWELL et al.: "Nonmechanical connection
technique for high-speed, high-density
integrated circuit applications", pages 1223-
1224

(73) Titulaire: **COMMISSARIAT A L'ENERGIE
ATOMIQUE Etablissement de Caractère
Scientifique Technique et Industriel
B.P. 510
F-75752 Paris Cedex 15 (FR)**

(72) Inventeur: **Buisson, Jacques
12, Avenue Faidherbe
F-91440 Bures Sur Yvette (FR)**
Inventeur: **Loitiere, Alain
17, rue des Fauvettes
F-91220 Le Plessis Pate (FR)**

(74) Mandataire: **Mongrédien, André et al
c/o BREVATOME 25, rue de Ponthieu
F-75008 Paris (FR)**

(56) Documents cités:
INSTITUTE OF ELECTRICAL AND
ELECTRONICS ENGINEERS. PROCEEDINGS OF
THE 20th ELECTRONIC COMPONENTS
CONFERENCE, 13-15 mai 1970, WASHINGTON
(US) R.J. CLARK et al.: "The application of the
STD process to hybrid microelectronics", pages
216-235

Courier Press, Leamington Spa, England.

## Description

La présente invention concerne un amplificateur linéaire hybride, ultra-rapide.

De façon plus précise, la présente invention se propose de réaliser un amplificateur linéaire possédant un temps de montée des impulsions électriques, après amplification, ultra-court. Un tel amplificateur linéaire peut être utilisé, en particulier, en électronique nucléaire où il est courant d'employer des amplificateurs de signaux dès leur entrée dans différents dispositifs comme, par exemple, dans les dispositifs relatifs à la sûreté des réacteurs.

Les amplificateurs linéaires connus, utilisés dans de tels dispositifs, présentaient de telles baisses de performance, aussi bien sur le gain d'amplification que sur le temps de montée des impulsions électriques, allant jusqu'à 20 nanosecondes, que leur fabrication a été totalement suspendue. De plus, ces circuits réalisés suivant la technologie monolithique, étaient réservés, à cause de leur coût, à la fabrication en grande série.

La présente invention a pour but un amplificateur linéaire hybride, ultra-rapide, permettant de remplacer ces amplificateurs à performances dégradées et possédant un temps de montés des impulsions électriques beaucoup plus court que le temps de montée de ces mémes amplificateurs.

Selon l'invention, cet amplificateur linéaire comprend un microcircuit électronique réalisé suivant la technologie hybride, possédant une bande passante très large et une montée ultrarapide des impulsions électriques, ce microcircuit comprenant sur un substrat isolant une pluralité de couches métalliques présentant une surface de métallisation minimum permettant d'assurer une liaison électrique d'une part, entre les différents composants dudit microcircuit, et d'autre part entre les différentes entrées et sorties électriques de l'amplificateur et les broches d'un boîtier dans lequel ledit amplificateur est implanté, cette liaison étant assurée uniquement par des fils conducteurs venant prendre contact sur la surface de métallisation, sans aucun contact avec le substrat isolant ce qui permet de diminner les capacité parasites dues à la metallisation.

Ce microcircuit présente l'avantage de posséder un temps de montée des impulsions électriques inférieur à 5 nanosecondes lonqu'il comprend les éléments tels qu'indiques dans la revendication 2.

Selon un mode préféré de l'invention, les résistances dudit microcircuit ont une largeur d'environ 50 $\mu$ pour une résistance carrée de 100 ohms et les transistors, réalisés suivant la technologie monolithique, sont rapportés par collage de façon que ledit microcircuit, réalisé suivant la technologie hybride, présente des dimensions voisines de celles que l'on obtiendrait avec un circuit intégré fabriqué suivant la technologie monolithique.

Cet amplificateur linéaire présente un certain nombre d'avantages et, en particulier, un temps de montée des impulsions électriques ultra-court, ce qui est indispensable au développement et à la maintenance d'appareillage nucléaire, ainsi que des dimensions voisines de celles que l'on obtient suivant la technologie monolithique. La fait d'avoir réalisé cet amplificateur linéaire suivant la technologie hybride permet de le fabriquer beaucoup plus rapidement et à un prix moins élevé que si on l'avait réalisé suivant la technologie monolithique.

D'autres caractéristiques et avantages de l'invention ressortiront mieux à l'aide de la description qui va suivre, donnée à titre purement illustratif et non limitatif, en référence aux figures annexées dans lesquelles:

— la figure 1 représente schématiquement le circuit électrique de l'amplificateur linéaire.
— la figure 2 représente un schéma d'implantation selon la technologie hybride du circuit électrique de l'amplificateur linéaire conformément à l'invention.
— la figure 3 représente schématiquement l'implantation du circuit hybride de la figure 2 dans un boîtier huit broches.

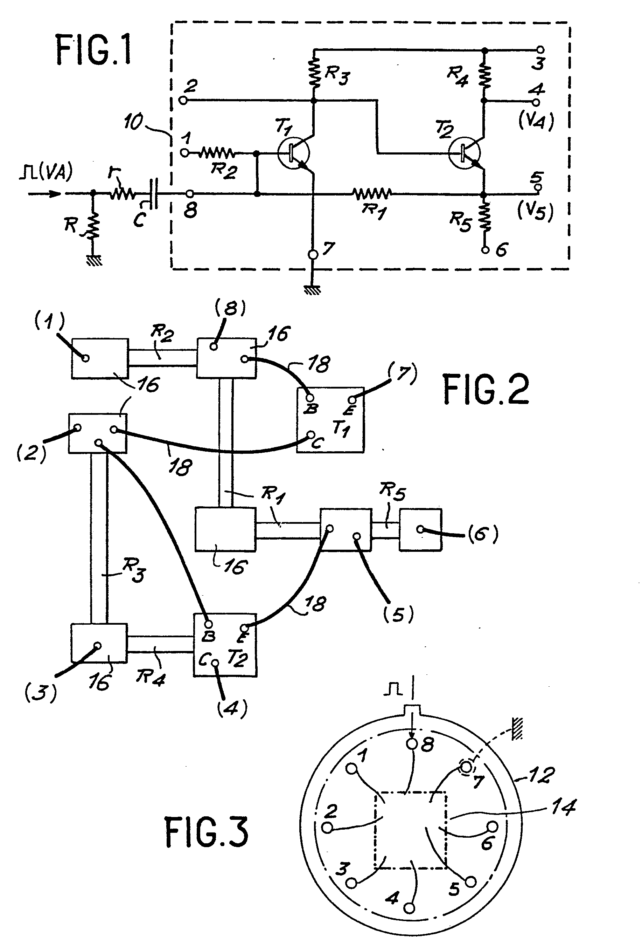

La figure 1 représente le microcircuit composant l'amplificateur linéaire. Ce microcircuit 10 représenté dans un cadre en pointillés comprend deux transistors $T_1$ et $T_2$, du type npn (2N3570) et cinq résistances $R_1$, $R_2$, $R_3$, $R_4$ et $R_5$ reliés entre eux et aux broches du boîtier 12 (figure 3) dans lequel est implanté ce microcircuit 10, de façon que:

— la base du transistor $T_1$ soit reliée d'une part à l'émetteur du transistor $T_2$ par l'intermédiaire d'une résistance $R_1$, et d'autre part à une première broche 1 du boîtier 12 par l'intermédiaire d'une résistance $R_2$;
— le collecteur du transistor $T_1$ soit relié d'une part directement à la base du transistor $T_2$, d'autre part directement à une deuxième broche 2 du boîtier 12, et aussi à une troisième broche 3 du boîtier 12 par l'intermédiaire d'une résistance $R_3$;
— le collecteur du transistor $T_2$ soit relié à la troisième broche 3 du boîtier 12 par l'intermédiaire d'une résistance $R_4$, et directement à une quatrième broche 4 du boîtier 12;
— l'émetteur du transistor $T_2$ soit relié, de plus, directement à une cinquième broche 5 du boîtier 12 et à une sixième broche 6 du boîtier 12 par l'intermédiaire d'une résistance $R_5$;
— l'émetteur du transistor $T_1$ soit relié directement à une septième broche 7 du boîtier 12 reliée elle-même au fond du boîter et representant la masse;
— la base du transistor $T_1$ soit reliée, de plus, directement à une huitième broche 8 du boîtier 12 correspondant à l'entrée des impulsions électriques (notées II) dans le microcircuit 10.

Ce circuit est attaqué en courant à la broche n° 8 du boîtier 12, schématisé sur la figure 3, par des impulsions délivrées par un générateur (non représenté) et alimentant une résistance r et un condensateur C placé en série.

Cet amplificateur linéaire hybride, ou microcircuit 10, est prévu pour remplacer les amplificateurs de l'art antérieur dans une chaîne de circuits électroniques bien définie. En conséquence, la résistance r ainsi que la tension d'entrée des impulsions électriques VA et les tensions de sortie, référencées $V_4$ et $V_5$ du microcircuit 10 ont des valeurs bien définies, ceci implique donc certaines conditions sur la valeur des résistances $R_1$, $R_4$ et $R_5$.

Ces conditions sont telles que:

$$\frac{V_5}{V_A} = 2 \text{ donc que } R_1 = 2r$$

$$\frac{V_4}{V_A} = 2 \times \frac{R_4}{R_5} = 8,66 \text{ donc que } R_4 = 4,33\, R_5$$

cette valeur (8,66) étant fonction du gain de l'amplificateur entre la tension d'entrée $V_A$ et la tension de sortie non chargée $V_5$. Comme r a une valeur imposée de 1 k$\Omega$, on a $R_1$ qui vaut 2 k$\Omega$ et si $R_5$ vaut 120 $\Omega$, $R_4$ vaut 520 $\Omega$.

Pour obtenir de bonnes performances de la part du microcircuit 10 (gain élevé et temps de montée ultracourt) $R_1$ ainsi que le rapport $R_4/R_5$ doivent avoir une précision de plus ou moins 5%.

En revanche, les autres résistances $R_2$ et $R_3$ peuvent être définies avec une précision de plus ou moins 20%. La résistance $R_2$ vaut environ 520 $\Omega$ et la résistance $R_3$ environ 2,7 k$\Omega$.

L'amplificateur ainsi réalisé présente une bande passante importante (de l'ordre de 60 MHz), ce qui lui confère un temps de montée des impulsions inférieur à 5 nanosecondes.

Les figures 2 et 3 représentent l'implantation du microcircuit décrit ci-dessus, dans un boîtier 12 à huit broches, référencées de 1 à 8, du type TO5. Le microcircuit 10 est réalisé suivant la technologie de l'hybridation.

Sur un substrat isolant 14 réalisé en verre ou en céramique sont déposées les couches métalliques conductrices 16 et les couches résistives. Les couches résistives sont réalisées de préférence, soit en nickel-chrome (NiCr), soit en nitrure de tantale ($Ta_2N$).

Le microcircuit 10 est réalisé par photogravure chimique avec différentes étapes de masquage et d'attaques chimiques selon les techniques habituelles utilisées en microélectronique hybride qui ne seront pas décrites ici.

Une fois que tout cela est fait, on peut souder ou coller les deux transistors $T_1$ et $T_2$ réalisés suivant la technologie monolithique, puis souder les fils conducteurs 18 réalisés de préférence en aluminium, par ultrason du fait de la faible surface de métallisation 16. Cette métallisation minimum 16 permet de diminuer les capacités parasites, dues à la métallisation, ce qui permet d'obtenir un amplificateur linéaire possédant un temps de montée des impulsions ultra-court. En effet, le temps de montée des impulsions électriques est inférieur à 5 nanosecondes.

La dimension de ce microcircuit hybride 10 définie par les amplificateurs linéaires selon la technologie monolithique implique que le microcircuit hybride 10 présente des dimensions voisines de celles que l'on obtiendrait suivant la technologie monolithique, ce qui représente une performance importante puisque jusqu'alors un microcircuit selon la technologie hybride était au moins vingt fois plus grand que ce même microcircuit réalisé selon la technologie monolithique. Cette performance vient non seulement de la taille des résistances ayant une largeur de 50 $\mu$ pour une résistance carrée de 100 $\Omega$, mais aussi de la métallisation 16 réduite à sa plus simple expression. Les fils conducteurs 18 permettant de relier le microcircuit 10 aux huit broches du boîtier 12 viennent prendre contact directement à l'intérieur dudit boîtier 12, avec les surfaces de métallisation.

Le microcircuit électrique 10 est réalisé sur un substrat 14 de 3,4 mm de côté, tandis que les huit broches du boîier sont implantées sur un diamètre de 5,84 mm.

De plus, du fait que la liaison entre les différents composants du microcircuit est réalisée par des fils conducteurs 18 permet de minimiser encore les surfaces de métallisation 16, ces fils conducteurs 18, réalisés en aluminium et de dimension inférieure à celle que l'on aurait pour une métallisation correspondante, présentent des capacités parasites beaucoup plus faibles. L'existence d'un substrat 14 isolant, et le fait que les fils conducteurs n'ont aucun contact avec ledit substrat ne créent pas de capacités parasites pouvant ralentir le temps de montée des impulsions électriques.

Il est à noter que dans cette implantation, la résistance $R_1$ est réalisée en deux parties placées à 90° l'une de l'autre, mais que la forme de cette résistance, ainsi que la forme des autres résistances pourraient être différentes.

Ce microcircuit hybride utilisé en électronique nucléaire est destiné à fonctionner en laboratoire dans des boîtiers équipant des tiroirs de mesure. Ce microcircuit n'est donc soumis à aucune contrainte thermique, mécanique, climatique, ce qui permet d'assurer les liaisons électriques entre les différents composants dudit circuit et les broches du boîtier par uniquement des fils conducteurs.

Dans la description ci-dessus, on a envisagé le cas d'une implantation dans un boîtier huit broches d'un microcircuit hybride, mais bien entendu, l'implantation d'un microcircuit hybride différent dans un boîtier possédant plus ou moins de 8 broches peut être envisagée.

## Revendications

1. Amplificateur linéaire ultra-rapide caractérisé en ce qu'il comprend un microcircuit électronique (10) réalisé suivant la technologie hybride, possédant une bande passante très large et une montée ultra-rapide des impulsions électriques, ce microcircuit (10) comprenant sur un substrat isolant (14) une pluralité de couches métalliques (16) présentant une surface de métallisation minimum permettant d'assurer une liaison électrique d'une part, entre les différents composants (transistors $T_1$ et $T_2$, résistances $R_1$, $R_2$, $R_3$, $R_4$ et $R_5$) dudit microcircuit (10) et, d'autre part entre les différentes entrées et sorties électriques de l'amplificateur et les broches (1 à 8) d'un boîtier (12) dans lequel ledit amplificateur est implanté, cette liaison étant assurée uniquement par des fils conducteurs (18) venant prendre contact sur le dites couche métalliques (16) sans aucun contact avec le substrat isolant (14) ce qui permet de diminuer les capacité parasites des à la métallisation.

2. Amplificateur linéaire selon la revendication 1, caractérisé en ce que le microcircuit (10) comprend deux transistors ($T_1$ et $T_2$) du type npn et cinq résistances $R_1$, $R_2$, $R_3$, $R_4$ et $R_5$, ces différents composants étant reliés entre eux de façon que:

— la base du transistor $T_1$ soit reliée d'une part à l'émetteur du transistor $T_2$ par l'intermédiaire d'une résistance $R_1$ de 2 kΩ et, d'autre part à une première broche (1) du boîtier (12) par l'intermédiaire d'une résistance $R_2$ de 520 Ω;

— le collecteur du transistor $T_1$ soit relié d'une part directement à la base du transistor $T_2$, d'autre part directement à une deuxième broche (2) du boîtier (12) et aussi à une troisième broche (3) du boîtier (12) par l'intermédiaire d'une résistance $R_3$ de 2,7 kΩ;

— le collecteur du transistor $T_2$ soit relié à ladite troisième broche (3) du boîtier (12) par l'intermédiaire d'une résistance $R_4$ de 520 Ω, et directement à une quatrième broche (4) du boîtier (12);

— l'émetteur du transistor $T_2$ soit relié, de plus, directement à une cinquième broche (5) du boîtier (12) et à une sixième broche (6) du boîtier (12) par l'intermédiaire d'une résistance $R_5$ de 120 Ω;

— l'émetteur du transistor $T_1$ soit relié directement à une septième broche (7) du boîtier (12) reliée elle-même au fond du boîtier et représentant la masse;

— la base du transistor $T_1$ soit reliée, de plus, à une huitième broche (8) du boîtier (12) correspondant à l'entrée des impulsions électriques dans le microcircuit (10).

3. Amplificateur linéaire selon l'une quelconque des revendications 1 et 2, caractérisé en ce que les résistances ($R_1$ à $R_5$) du microcircuit (10) ont une largeur d'environ 50 $\mu$ pour une résistance carrée de 100 ohms et les transistors ($T_1$ et $T_2$) sont réalisés suivant la technologie monolithique de façon que ledit microcircuit (10) réalisé suivant la technologie hybride présente des dimensions voisines de celles que l'on obtiendrait avec un circuit intégré fabriqué suivant la technologie monolithique.

4. Amplificateur linéaire selon l'une quelconque des revendications 1 à 3, caractérisé en ce que le substrat (14) est un isolant choisi parmi le groupe comprenant le verre et la céramique.

5. Amplificateur linéaire selon l'une quelconque des revendications 1 à 4, caractérisé en ce que les fils conducteurs (18) sont réalisés en aluminium.

6. Amplificateur linéaire selon l'une quelconque des revendications 1 à 5, caractérisé en ce que les résistances ($R_1$ a $R_5$) sont réalisées en un matériau choisi dans le groupe comprenant le nitrure de tantale et le nickel-chrome.

## Patentansprüche

1. Ultraschneller Linear-Verstärker, dadurch gekennzeichnet, daß er einen in Hybridtechnik hergestellten, elektronischen Mikroschaltkreis (10) umfaßt, der einen sehr breiten Durchlaßbereich und einen ultraschnellen Anstieg der elektrischen Impulse aufweist, und daß der Mikroschaltkreis (10) auf einem isolierenden Substrat (14) eine Vielzahl von metallischen Schichten (16) aufweist, die eine Oberfläche mit minimaler Metallisierung darstellen, wodurch eine elektrische Verbindung einerseits zwischen den verschiedenen Bauteilen (Transistoren $T_1$ und $T_2$, Widerständen $R_1$, $R_2$, $R_3$, $R_4$ und $R_5$) des Mikroschaltkreises (10) und andererseits zwischen den verschiedenen elektrischen Eingängen und Ausgängen des Verstärkers und den Klemmen (1 bis 8) eines Gehäuses (12) sichergestellt ist, in dem der Verstärker untergebracht ist, wobei diese Verbindung ausschließlich durch leitende Drähte (18) erfolgt, die sich in Kontakt mit den metallischen Schichten (16) ohne irgendwelchen Kontakt mit dem isolierenden Substrat (14) befinden, wodurch die Störkapazität aufgrund der Metallisierung verringerbar ist.

2. Linear-Verstärker nach Anspruch 1, dadurch gekennzeichnet, daß der Mikroschaltkreis (10) zwei Transistoren ($T_1$ und $T_2$) vom npn-Typ und fünf Widerstände ($R_1$, $R_2$, $R_3$, $R_4$ und $R_5$) umfaßt, wobei diese verschiedenen Bauteile derart miteinander verbunden sind,

daß die Basis des Transistors $T_1$ einerseits mit dem Emitter des Transistors $T_2$ über einen Widerstand $R_1$ von zwei kΩ und andererseits mit einer ersten Klemme (1) des Gehäuses (12) über einen Widerstand $R_2$ von 520 Ω verbunden ist,

daß der Kollektor des Transistors $T_1$ einerseits

unmittelbar mit der Basis des Transistors $T_2$ und andererseits unmittelbar mit einer zweiten Klemme (2) des Gehäuses (12) und auch einer dritten Klemme (3) des Gehäuses (12) über einen Widerstand $R_3$ von 2,7 k$\Omega$ verbunden ist,

daß der Kollektor des Transistors $T_2$ mit der dritten Klemme (3) des Gehäuses (12) über einen Widerstand $R_4$ von 520 $\Omega$ und unmittelbar mit einer vierten Klemme (4) des Gehäuses (12) verbunden ist,

daß der Emitter des Transistors $T_2$ ferner unmittelbar mit einer fünften Klemme (5) des Gehäuses (12) und einer sechsten Klemme (6) des Gehäuses (12) über einen Widerstand $R_5$ von 120 $\Omega$ verbunden ist,

daß der Emitter des Transistors $T_1$ unmittelbar mit einer siebten Klemme (7) des Gehäuses (12) verbunden ist, die selbst mit dem Boden des Gehäuses verbunden ist und den Masseanschluß darstellt, und

daß die Basis des Transistors $T_1$ ferner mit einer achten Klemme (8) des Gehäuses (12) verbunden ist, die dem Eingang für die elektrischen Impulse in den Mikroschaltkreis (10) entspricht.

3. Linear-Verstärker nach Anspruch 1 oder 2, dadurch gekennzeichnet, daß die Widerstände ($R_1$ bis $R_5$) des Mikroschaltkreises (10) eine Breite von ungefähr 50 $\mu$ für einen quadratischen Widerstand von 100 $\Omega$ aufweisen und daß die Transistoren ($T_1$ und $T_2$) gemäß der monolithischen Technik derart hergestellt sind, daß der gemäß der Hybridtechnik hergestellte Mikroschaltkreis (10) Abmessungen aufweist, die nahe demjenigen liegen, welche bei einem nach der monolithischen Technik hergestellten, integrierten Schaltkreis erhalten werden.

4. Linear-Verstärker nach irgendeinem der Ansprüche 1 bis 3, dadurch gekennzeichnet, daß das Substrat (14) ein Isolator ist, der aus der Glas und Keramik umfassenden Gruppe ausgewählt ist.

5. Linear-Verstärker nach irgendeinem der Ansprüche 1 bis 4, dadurch gekennzeichnet, daß die leitenden Drähte (18) aus Aluminium sind.

6. Linear-Verstärker nach irgendeinem der Ansprüche 1 bis 5, dadurch gekennzeichnet, daß die Widerstände ($R_1$ und $R_5$) aus einem Material hergestellt sind, welches aus der Tantalnitrid und Nickel-Chrom umfassenden Gruppe ausgewählt ist.

## Claims

1. Ultra-fast linear amplifier characterized in that it comprises an electronic microcircuit (10) formed by hybrid technology, having a very wide pass band and an ultra-fast transmission of electrical pulses, said microcircuit (10) comprising an insulating substrate (14) having thereon a plurality of metallic deposits (16) having the minimum metal surface required to ensure electrical connection, on the one hand between the different components (transistors $T_1$ and $T_2$, resistances $R_1$, $R_2$, $R_3$, $R_4$ and $R_5$) of said microcircuit (10), and, on the other hand between the different electrical inputs and outputs of the amplifier, and the terminals (1 to 8) of a housing (12) in which said amplifier is enclosed, said connection being exclusively provided by conductive wires (18) contacting said metal deposits (16), without any contact with the insulating substrate (14), thereby diminishing the parasitic capacitance due to metallisation.

2. Linear amplifier according to Claim 1, characterized in that the microcircuit (10) comprises two npn transistors ($T_1$ and $T_2$) and five resistances ($R_1$, $R_2$, $R_3$ $R_4$ and $R_5$), said different components being interconnected so that:—

— the base of transistor $T_1$ is connected, on the one hand, to the emitter of transistor $T_2$ through a resistance $R_1$ of 2 K$\Omega$ and, on the other hand, to a first terminal (1) of the housing (12) through a resistance $R_2$ of 520 $\Omega$;

— the collector of transistor $T_1$ is connected, on the one hand, directly to the base of transistor $T_2$ and, on the other hand, directly to a second terminal (2) of housing (12) and also, through a resistance $R_3$ of 2.7 K$\Omega$, to a third terminal (3) of the housing (12);

— the collector of transistor $T_2$ is connected to the said third terminal (3) of housing (12) through a resistance $R_4$ of 520 $\Omega$, and directly to a fourth terminal (4) of the housing (12);

— the emitter of transistor $T_2$ is additionally connected directly to a fifth terminal (5) of the housing (12), and through a resistance $R_5$ of 120 $\Omega$ to a sixth terminal (6) of the housing;

— the emitter of transistor $T_1$ is directly connected to a seventh terminal (7) of the housing, which is itself connected to the base of the housing representing earth; and

— the base of transistor ($T_1$) is additionally connected to an eighth terminal (8) of the housing (12) corresponding to the input of electrical pulses into the microcircuit (10).

3. Linear amplifier according to either of Claims 1 and 2, characterized in that the resistances ($R_1$ to $R_5$) of the microcircuit (10) have lengths of around 50 $\mu$ for a unit resistance of 100 ohms, and the transistors ($T_1$ and $T_2$) are produced by solid state technology, whereby said microcircuit (10) formed by hybrid technology has dimensions near those obtainable with an integrated circuit formed by solid state technology.

4. Linear amplifier according to any one of Claims 1 to 3, characterized in that the substrate (14) is an insulator selected from the group comprising glasses and ceramics.

5. Linear amplifier according to any one of Claims 1 to 4, characterized in that the conductive wires (18) are made of aluminium.

6. Linear amplifier according to any one of Claims 1 to 5, characterized in that the resistances $(R_1$ to $R_5)$ are formed of a material selected from the group comprising tantalum nitride and nickel-chrome.

FIG.1

FIG.2

FIG.3